(19) Europäisches Patentamt
European Patent Office
Office européen des brevets

(11) EP 0 546 537 B1

(12) **EUROPEAN PATENT SPECIFICATION**

(45) Date of publication and mention
of the grant of the patent:
**11.09.1996 Bulletin 1996/37**

(51) Int Cl.⁶: **H03H 17/06**

(21) Application number: **92121054.8**

(22) Date of filing: **10.12.1992**

(54) **Electronic device for the automatic conversion of sampled frequencies**

Elektronische Anordnung für automatische Umwandlung von Abtastfrequenzen

Dispositif électronique pour la conversion automatique de fréquences d'échantillonnage

(84) Designated Contracting States:
**DE FR GB**

(30) Priority: **13.12.1991 IT MI913348**

(43) Date of publication of application:
**16.06.1993 Bulletin 1993/24**

(73) Proprietor: **SGS-THOMSON
MICROELECTRONICS S.r.l.
I-20041 Agrate Brianza (Milano) (IT)**

(72) Inventors:
• **Airoldi, Fabrizio
I-28040 Seriolo Di Baveno (Novara) (IT)**
• **Cremonesi, Alessandro
I-20079 Sant'Angelo Lodigiano (Milano) (IT)**

(74) Representative: **Checcacci, Giorgio
PORTA, CHECCACCI & BOTTI s.r.l.
Viale Sabotino, 19/2
I-20135 Milano (IT)**

(56) References cited:
**EP-A- 0 401 562          US-A- 4 954 824**

## Description

This invention relates to an electronic device for the automatic conversion of sampling frequencies, being a type adapted to convert a predetermined frequency of a sampled input signal to a desired output signal frequency.

The field of application of this invention is in particular, but not solely, that of the sampling frequency converters used in receiver sets of high resolution TV signals, and the description herein below will make reference to that field of application for convenience of illustration.

As is well recognized, high resolution or defintion TV, sets require that conversions of the video signal sampling frequency be carried out automatically.

TV sets of that type comprise a decoder block for which the sampling frequency is set to a predetermined value which is usually four times the value of the subcarrier frequency Fsc for the television standard adopted, e.g. 17.7 MHz for the European standard known as PAL, and 14.3 MHz for the US standard NTSC.

But, where the TV set operation is more closely tied to the picture geometry, a multiple of the line frequency Mfl=13.5 MHz is used instead. Such is the case, for example, with a line-duplication operating technique, whereby the frequency at which the picture is displayed on the screen is duplicated to avoid the flicker that typically affects ordinary TV sets.

Thus, a frequency conversion becomes necessary between the sampled input video signal, at a frequency CKIN equal 4Fsc, and the output signal, at line frequency CKOUT=Mfl, if best operating conditions are to be ensured for both the decoder and the scan converter block.

This frequency conversion is of vital importance to the video signal processing because a faulty conversion would result in loss of all the benefits of high resolution.

The prior art has proposed a frequency converting method which consists of performing in cascade a double conversion, digital-to-analog and analog-to-digital.

Basically, a signal to be converted, as sampled at frequency CKIN, is first rebuilt by translation from digital into analog and directly afterwards sampled at the desired output frequency CKOUT.

However, this known approach has the disadvantage of introducing high distortion in the signal, due indeed to the double conversion.

To overcome this drawback, the prior art has proposed another solution which consists of performing a discrete time operation which is the equivalent of the digital-to-analog and analog-to-digital conversion sequence, using a sampling device.

This prior method does prevent the distortion introduced by the analog conversion, but involves the use of a sampling device of considerable complexity circuitwise and the need to operate at high scanning frequencies.

EP-A-0 401 562 discloses a sampling frequencies converting device comprising a digital filter and a selection device, which operates receiving input and output signal frequencies and selecting by an address-memory a predetermined interpolation coefficient to be supplied to the digital filter.

Another example of prior art is US-A-4 954 824.

The underlying technical problem of this invention is to provide an electronic device having such structural and functional features as to enable automatic conversion of sampling frequencies, to thereby overcome the drawbacks which beset the prior art.

This technical problem is solved by a device as indicated being characterized in that it comprises: a phase detector receiving as inputs both the input signal and the output signal frequencies; a decoder block associated with the phase detector to determine an interpolation coefficient; an interpolator filter having a digital input for encoding the sampling signal, and receiving the input frequency, on the one side, and a digital signal representative of said coefficient from an output of the decoder block, on the other side; a synchronizer, connected after the filter and receiving as inputs both said input and output frequencies, and having a digital output for encoding the converted sampling signal; and a register connected between the decoder output and the interpolation filter input.

The features and advantages of an electronic device according to the invention will be apparent from the following detailed description of an embodiment thereof, given by way of example and not of limitation with reference to the accompanying drawings.

In the drawings:

Figure 1 shows diagramatically an electronic device, according to the invention, for converting sampling frequencies automatically;

Figure 2 shows diagramatically signal waveforms having the same time base and appearing in the device of Figure 1;

Figure 3 shows diagramatically a detail of the device in Figure 1;

Figure 4 shows diagramatically another detail of the device in Figure 1; and

Figure 5 is a diagramatic representation of a further detail of the device in Figure 1.

With reference to the drawing figures, generally and schematically shown at 1 is an electronic device for the automatic conversion of sampling frequencies, embodying this invention.

In particular, though not exclusively, the device 1 is intended for use in high picture resolution TV sets, not shown because conventional.

This device 1 converts the frequency CKIN of a sampling input signal to the frequency CKOUT of a desired output signal.

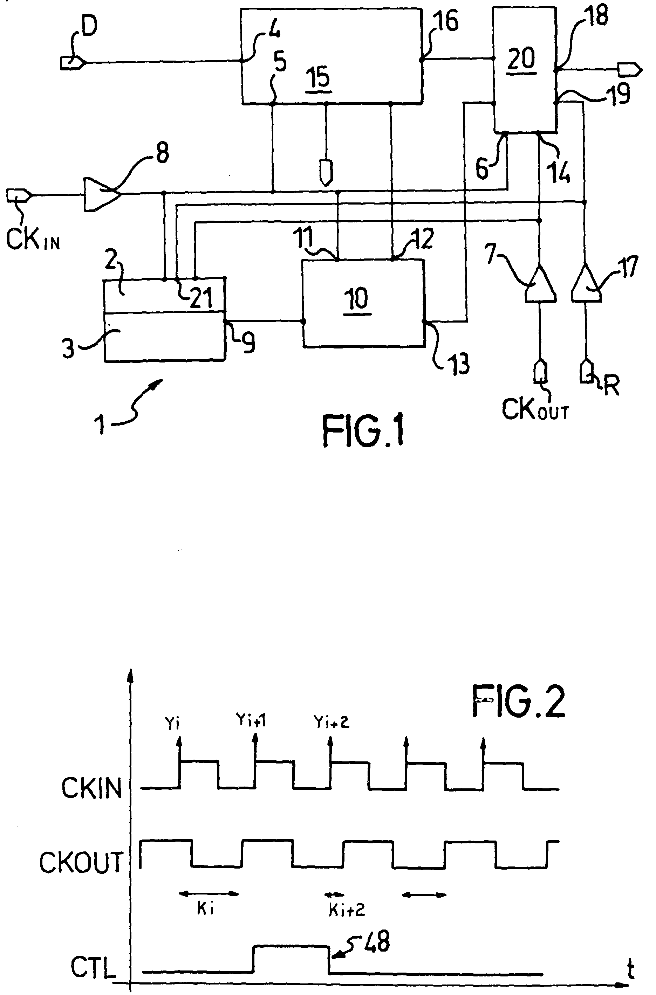

The pattern of such signals versus time t is illustrated by the graph in Figure 2.

It is assumed that the input frequency is at all times higher than the output frequency, which would allow the device 1 to only perform conversions to lower frequencies.

For this purpose, the device 1 comprises a phase detector 2 which is input a signal at frequency CKIN via an amplifier 8.

This detector 2 also receives, on another input, the signal at frequency CKOUT, fetched after an amplifier 7.

Closely associated with said detector 2 is a decoder block 3 for an interpolation coefficient K to be explained.

The block 3 has a six-bit digital bus output 9 connected to an input of a master/slave register 10.

This register 10 also receives, on an input 11, the signal at frequency CKIN and has, moreover, respective outputs 12, 13 which are connected, the one to an interpolator filter 15 and the other to a sunchronizer 20.

Both the filter 15 and the synchronizer 20 receive the signal at frequency CKIN on respective inputs 5 and 6; applied to another input 14 of the synchronizer 20 is also the signal at frequency CKOUT.

The filter 15 is also provided with an eight-pin input 4 receiving an eight-bit digital signal D representative of the coding of the sample signal to be converted frequency-wise, and an eight-pin digital output 16 connected directly to the synchronizer 20.

The filter 15 is assigned the task of implementing an interpolation algorithm, explained hereinafter, while the synchronizer 20 functions substantially as a storage structure of the FIFO type having a write section driven by the signal at frequency CKIN and a read section driven by the signal CKOUT, under control by a signal CTL from the output 13 of the register 10 which inhibits writing in storage locations whose contents have not been previously read out.

The digital output of the synchronizer 20 is indicated at 18 and comprises eight pins to which the digital coding of the converted signal is presented.

For completeness of description, it should be also noted that a reset and enable signal R is applied, through an amplifier 17, to an input 21 of the detector 2 and to an input 19 of the synchronizer 20.

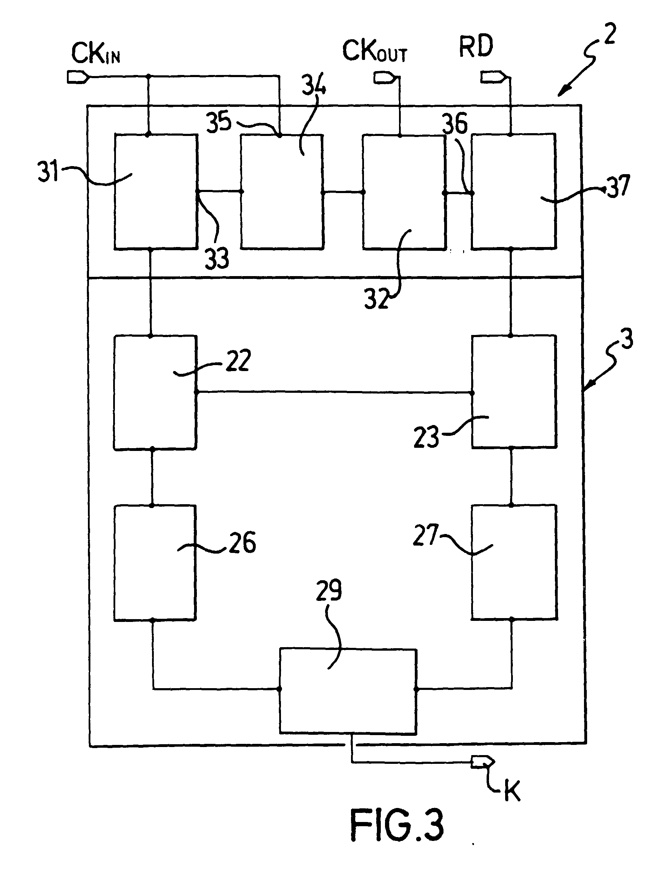

The constructions of the phase detector 2 and the decoder block 3 will now be described in greater detail with reference to the embodiment shown in Figure 3.

The detector 2 comprises a pair of samplers 31, 32 being respectively input, the one the signal at freuency CKIN and the other the signal at frequency CKOUT.

The first sampler 31 has an output 33 connected to an input of an analog delay block 34 which, in turn, receives the signal at frequency CKIN on another input 35.

The single output of said block 34 is connected inputwise to the other sampler 32, which has its output connected to an input 36 of a sense device 37 operative to provide an estimate of the so-called instant phase relationship, denoted by A hereinafter, between the frequencies CKIN and CKOUT.

Also shown in Figure 3 is the block 3 associated with the detector 2, which block comprises a pair of decoders 22 and 23, with the former being connected after the first sampler 31, and the latter connected to the output of the sensor 37.

Within the first decoder 22, the value B of the input frequency CKIN period is obtained, whilst in the second decoder 23, there is obtained the value of the aforesaid instant phase relationship A.

The structure of the block 3 is completed by a pair of encoders 26 and 27 respectively connected after the first decoder 22 and the second decoder 23.

The first, 26, of said encoders is for computing the digital coding of the value 1/B, and the other encoder, 27, for carrying out the conversion of the value A into the digital code.

A multiplexer 29 is input the respective outputs from the encoders 26 and 27 to output a six-bit digital signal representing an interpolation coefficient K given by the A/B ratio.

The actual implementation of the phase detector 2 circuit-wise provides for a circuit portion 40 to be closely associated with it which is effective to constantly monitor the frequencies CKIN and CKOUT in order to prevent the simultaneous appearance of two rising edges of the signals from hindering the flow of data to the master/slave register 10.

Since the period of frequency CKOUT is greater than that of frequency CKIN, there will occur situations periodically where two successive rising edges of the signal CKIN at a higher frequency present themselves after a single rising edge of the lower-frequency signal.

This situation is identified by the term "empty space" and illustrated in Figure 2 by a segment 48 of the control signal CTL.

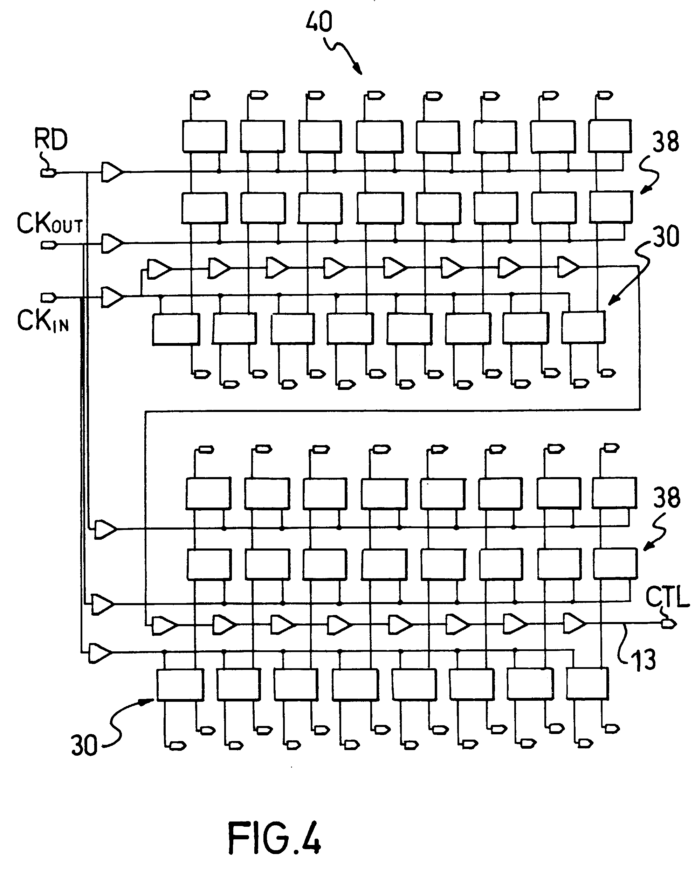

Shown in Figure 4 is an example of the construction of said circuit portion 40 being incorporated to the detector 2 and having essentially a first storage portion of the master type and a second portion of the slave type which is to serve the functions of the register 10.

Specifically, a first, one hundred and twenty eight-bit register 38 switched over by the rising edge of the signal at frequency CKOUT, is connected in parallel with a second, one hundred and twenty eight-bit register 30 which is controlled by the scan frequency CKIN.

Thus, that portion which stores the output from the sampler 32 controlled by the rising edge of the signal CKOUT will be considered to be the master portion.

A read enable signal RD is controlled by the rising edge of the signal CKIN and triggers the transfer of data from the master portion to the slave portion of the control circuit 40.

This signal RD is generated by an auxiliary circuit 45 based on an operational protocol described herein below.

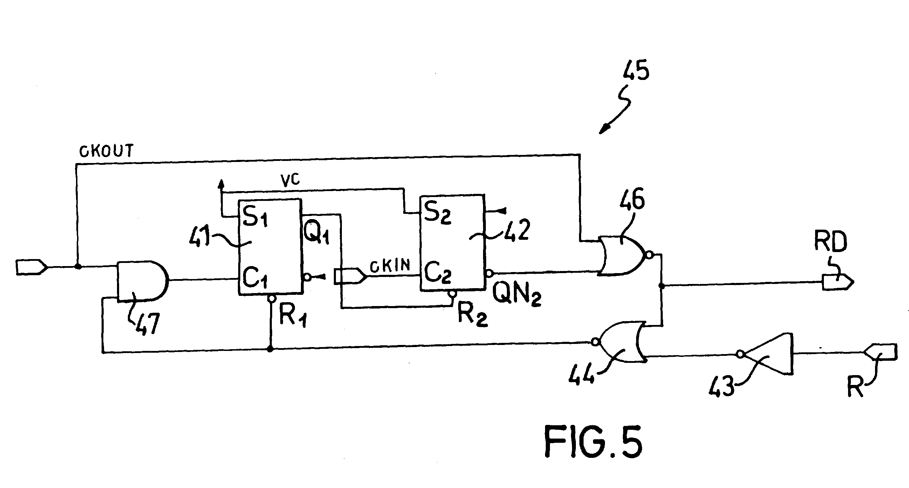

The circuit 45 is shown in Figure 5 as comprising a bistable pair 41 and 42, such as two SCR flip-flops which have respective set inputs S1, S2 held at a logic high for connection to a supply pole Vc.

Applied respectively to other, or clear, inputs C1, C2 are the signals at frequency CKOUT and frequency CKIN.

In particular, the signal CKOUT is applied to an input of a logic AND gate 47 which receives, on the other input thereof, the initialization signal R.

The output of said gate 47 is connected to the clear input C1 of the first bistable, which has its output Q1 connected directly to the reset input R2 of the second bistable 42.

To the reset input R1 of the first bistable 41 there is applied instead the initialization signal R, through an inverter 43 and a logic NOR gate 44 having two inputs.

The negated output QN2 from the second bistable 42 generates the signal RD and is connected to one input of a logic gate 46 receiving, on the other input thereof, the signal at frequency CKOUT.

The output of this gate 46 is applied to the other input of the other logic gate 44.

The method of operating the device 1 of this invention will now be described which, on the whole, can be said to be asynchronous in that it uses two signals whose frequencies are unrelated to each other.

This device 1 can carry out the frequency conversion by means of a linear interpolation algorithm, for example, as given by the following formula:

$$(1) \qquad Yout=(1-K)*Yn+K*Yn+1$$

where, Yout is the output signal obtained from a weighted mean of n plural contiguous signals multiplied by the weight coefficient K, which constitutes the single independent variable in this relation.

Advantageously according to the invention, the coefficient K is computed as the A/B ratio of the instant phase relationship A, between the frequencies CKIN and CKOUT, to the period B of just the input frequency CKIN:The resulting coefficient K may be defined as a "normalized instant phase relationship".

More particularly, this device 1 carries out the conversion using a more sophisticated interpolation algorithm, as given by the following relation:(2) Yout=Y1*K1+Y2*K2+Y3*K3+Y4*K4where the various weight coefficients Ki are a function fi(K) of the aforementioned coefficient K.

The device of this invention performs the sampling frequency conversion in two discrete steps.

First, the valuer Yout of the interpolation data is computed synchronously with the frequency CKIN; thereafter, this value is latched to the frequency CKOUT, to thus complete the conversion operation.

To this aim, at each scan pulse of the input signal, the detector 2 effects an estimate of the instant phase relationship A and the period B of frequency CKIN.

The block 3 is also to compute the weight coefficient K=A/B previously referred to as the normalized instant phase relationship.

The coefficient K is encoded on a six-bit bus and corresponds essentially to an interpolation factor M=26=64.

This coefficient K is transferred to the interpolation filter 15 which will implement the algorithm according to formula (2) above, to thus effect a so-called four-range weighted mean of the sampled signals D.

In essence, the weighted mean is carried out on four contiguous inputs of the sampled signal D, and the weight coefficients K can be stored in a programmable read-only memory whence the best interpolation factor can be read out consistently with the characteristics of the signal D.

Lastly, the synchronizer 20 will transform the interpolated values of the signal D, at frequency CKIN, into the output frequency CKOUT; all this under control by the signal CTL which reveals any overlap in the input and output frequencies to promote phase readjustment within the synchronizer 20.

Specifically, it should be also considered that the inventive device is to handle the transfer of data into the register 10 even under an asynchronous condition of the working frequencies CKIN and CKOUT.

Let us take, for example, the instance of fresh data being stored into the master portion of the control circuit 40.

Fresh data means here the output from the delay chain 32 as sampled by the rising edge of the signal CKOUT.

If such fresh data is in a steady state, then the slave portion of circuit 40 can read it out upon the control signal RD being triggered.

The read control signal RD is controlled by the rising edge of the signal at frequency CKIN, and it is necessary to remember whether said rising edge occurred before the data stored in the master portion had attained a steady state.

Otherwise, it becomes necessary to wait for a fresh rising edge and the generation of a fresh read control signal RD.

This check is effected by the control circuit 40 in accord with the following operational protocol.

It has been assumed that the half-period of the signal CKout is adequate to ensure stabilization of the data in the master portion of circuit 40.

Accordingly, the period of the signal CKOUT is used as an indicator of the data validity.

On the arrival of a rising edge of the signal CKOUT, the output Q1 of the bistable 41 is switched to a logic high, thereby enabling the other bistable 42.

Thus, the arrival of the rising edge of the signal CKIN brings the output QN2 of the second bistable 42 to a logic high.

If the data is presently judged to be valid, for the reasons explained in connection with the period of CKOUT, then the read enable signal RD is generated.

It matters to consider here the presence of the AND gate 47 which would only be open during the readout and reset operations in order to prevent loss of any rising edge of the signal CKOUT, and the consequent transfer of data to the slave portion from the master portion.

Upon generation of the signal RD, the reset operation is started at once because the initialization signal R corresponds to the inverted signal RD being applied to the input R1 of the bistable 41.

The reset operation is complete with the return of RD to a logic low, and the circuit 45 is ready for a fresh operation cycle.

In the event of a so-called empty space being input, that is when two rising edges of the frequency CKIN come in following a single edge of CKOUT, the control signal CTL is generated to drive the slave portion only of the circuit 40.

Accordingly, the transfer of data to the slave portion from the master portion can be ensured at all times and in any case, irrespective of the asynchronous condition of the frequencies CKIN and CKOUT.

The device of this invention does solve the technical problem in an effective way and with reduced circuit complexity.

In addition, this device can be operated in a multi-standard mode because it can convert input frequencies automatically within a 10 to 27 MHz band.

## Claims

1. An electronic device for the automatic conversion of sampling frequencies, being a type adapted to convert a predetermined frequency (CKIN) of a sampled input signal (D) to a desired output signal frequency (CKOUT), characterized in that it comprises:

   a phase detector (2) receiving as inputs both the input signal (CKIN) and the output signal (CKOUT) frequencies;

   a decoder block (3) associated with the phase detector (2) to determine an interpolation coefficient (K);

   an interpolator filter (15) having a digital input (4) for encoding the sampling signal, and receiving the input frequency (CKIN), on the one side, and a digital signal representative of said coefficient (K) from an output (9) of the decoder block (3), on the other side;

   a synchronizer (20), connected after the filter (15) and receiving as inputs both said input (CKIN) and output (CKOUT) frequencies, and having a digital output (18) for encoding the converted sampling signal; and

   a register (10) connected between the decoder output (9) and the interpolation filter (15) input.

2. A device according to Claim 1, characterized in that a control output (13) from said register (10) is also applied to a further input of the synchronizer (20).

3. A device according to Claim 1, characterized in that said register (10) is closely associated with the phase detector (2) and comprises a master storage portion (38) being switched over by the rising edge of the signal at output frequency (CKOUT) and connected in parallel to another, corresponding storage portion (30) of the slave type controlled by the signal at input frequency (CKIN).

4. A device according to Claim 1, characterized in that it further comprises an auxiliaty circuit (45) for generating a read enable signal (RD) to read out data from the master portion to the slave portion of said register (10).

5. A device according to Claim 4, characterized in that said auxiliary circuit (45) comprises:a bistable pair (41,42) having respective set inputs (S1,S2) connected to a supply pole Vc and further, clear inputs (C1,C2) whereto the signals at the output and input frequencies (CKOUT,CKIN) are respectively supplied; the output (Q1) of a first (41) of the bistables being connected directly to a reset input (R2) of the second bistable (42);an initialization signal (R) applied to a reset input (R1) of the first bistable (41) through an inverter (43); anda logic NOR gate (46) having two inputs and receiving said output frequency (CKOUT) and the signal from the negated output (QN2) of the second bistable (42) to generate said enable signal (RD).

6. A high picture resolution TV set, characterized in that it incorporates an electronic device for the automatic conversion of sampling frequencies as claimed in Claim 1.

## Patentansprüche

1. Elektronische Vorrichtung zum automatischen Umwandeln von Abtastfrequenzen, bei der eine vorbestimmte Frequenz (CKIN) eines abgetasteten Eingangssignals (D) umgewandelt wird in eine gewünschte Ausgangssignalfrequenz (CKOUT), **gekennzeichnet durch**:

   einen Phasendetektor (2), der als Eingangssignal sowohl die Eingangssignalfrequenz (CKIN) als auch die Ausgangssignalfrequenz (CKOUT) empfängt;

einen Decoderblock (3), der dem Phasendetektor (2) zugeordnet ist, um einen Interpolationskoeffizienten (K) zu bestimmen;

ein Interpolierfilter (15) mit einem Digitaleingang (5) zum Codieren des Abtastsignals, und zum Empfangen der Eingangsfrequenz (CKIN) einerseits sowie eines für den Koeffizienten (K) repräsentativen Digitalsignals von einem Ausgang (9) des Decoderblocks (3) andererseits;

einen Synchronisator (20), der dem Filter (15) nachgeschaltet ist und als Eingangsgrößen sowohl die Eingangs-(CKIN) als auch die Ausgangsfrequenz (CKOUT) empfängt und einen Digitalausgang (18) zum Codieren des umgewandelten Abtastsignals besitzt; und

ein Register (10), welches zwischen dem Decoderausgang (9) und dem Eingang des Interpolierfilters (15) liegt.

2. Vorrichtung nach Anspruch 1,
**dadurch gekennzeichnet**,
daß ein Steuerausgang (13) des Registers (10) an einen weiteren Eingang des Synchronisators (20) geführt ist.

3. Vorrichtung nach Anspruch 1,
**dadurch gekennzeichnet**,
daß das Register (10) dem Phasendetektor (2) eng zugeordnet ist und einen Master-Speicherabschnitt (38) aufweist, der durch die Anstiegsflanke des Signals mit der Ausgangsfrequenz (CKOUT) umgeschaltet wird und parallel geschaltet ist zu einem weiteren, zugehörigen Slave-Speicherabschnitt (30), der von dem Signal mit der Eingangsfrequenz (CKIN) gesteuert wird.

4. Vorrichtung nach Anspruch 1,
**dadurch gekennzeichnet**,
daß sie weiterhin einen Hilfsschaltkreis (45) zum Erzeugen eines Lesefreigabesignals (RD) zum Auslesen von Daten aus dem Master-Abschnitt in den Slave-Abschnitt des Registers (10) aufweist.

5. Vorrichtung nach Anspruch 4,
**dadurch gekennzeichnet**,
daß der Hilfsschaltkreis (45) aufweist: ein Paar Flipflops (41, 42), die jeweils Setzeingänge (S1, S2) besitzen, die an einen Versorgungsspannungsanschluß (Vc) angeschlossen sind, und die außerdem Löscheingänge (C1, C2) aufweisen, denen die Signale mit der Ausgangs- bzw. Eingangsfrequenz (CKOUT, CKIN) zugeführt werden, wobei der Ausgang (Q1) eines ersten Flipflops (41) direkt mit einem Rücksetzeingang (R2) des zweiten Flipflops (42) verbunden ist; ein Initialisierungssignal (R) einem Rücksetzeingang (R1) des ersten Flipflops (41) über einen Negator (43) zugeführt wird, und ein logisches NOR-Gatter (46), welches zwei Eingänge besitzt und die Ausgangsfrequenz (CKOUT) und das Signal von dem negierten Ausgang (QN2) des zweiten Flipflops (42) empfängt, um das Lesefreigabesignal (RD) zu erzeugen.

6. Hochauflösendes Fernsehgerät,
**dadurch gekennzeichnet**,
daß es eine elektronische Vorrichtung zum automatischen Umwandeln von Abtastfrequenzen nach Anspruch 1 enthält.

## Revendications

1. Dispositif électronique pour la conversion automatique des fréquences d'échantillonnage, d'un type adapté pour convertir une fréquence prédéterminée (CKIN) d'un signal d'entrée échantillonné (D) en une fréquence souhaitée d'un signal de sortie (CKOUT), caractérisé en ce qu'il comprend :

un détecteur de phase (2) recevant sur ses entrées à la fois la fréquence du signal d'entrée (CKIN) et la fréquence du signal de sortie (CKOUT) ;
un bloc décodeur (3) associé au détecteur de phase (2) pour déterminer un coefficient d'interpolation (K) ;
un filtre d'interpolation (15) ayant une entrée numérique (4) pour coder le signal d'échantillonnage, et recevoir la fréquence d'entrée (CKIN), d'une part, et un signal numérique représentatif dudit coefficient (K) délivré par la sortie (9) du bloc décodeur (3), d'autre part ;
un synchronisateur (20), connecté après le filtre (15) et recevant sur ses entrées à la fois lesdites fréquences d'entrée (CKIN) et de sortie (CKOUT), et ayant une sortie numérique (18) pour coder le signal d'échantillonnage converti ; et
un registre (10) connecté entre la sortie (9) du décodeur et l'entrée (15) du filtre d'interpolation.

2. Dispositif selon la revendication 1, caractérisé en ce qu'une sortie de commande (13) dudit registre (10) est également appliquée à une autre entrée du synchronisateur (20).

3. Dispositif selon la revendication 1, caractérisé en ce que ledit registre (10) est étroitement associé au détecteur de phase (2) et comprend une partie de mémoire maître (38) qui est commutée par le front montant du signal à la fréquence de sortie (CKOUT) et connectée en parallèle avec une autre partie de mémoire correspondante (30) de type esclave commandée par le signal à la fréquence d'entrée (CKIN).

4.  Dispositif selon la revendication 1, caractérisé en ce qu'il comprend encore un circuit auxiliaire (45) pour produire un signal de validation de lecture (RD) destiné à lire des données dans la partie maître pour les introduire dans la partie esclave dudit registre (10).

5.  Dispositif selon la revendication 4, caractérisé en ce que ledit circuit auxiliaire (45) comprend : une paire de circuits bistables (41, 42) ayant des entrées respectives de positionnement (S1, S2) connectées à un pôle d'alimentation Vc et aussi, des entrées d'annulation (C1, C2) sur lesquelles les signaux des fréquences de sortie et d'entrée (CKOUT, CKIN) sont respectivement appliqués ; la sortie (Q1) d'un premier (41) des circuits bistables étant directement connectée à une entrée de remise à l'état initial (R2) du second circuit bistable (42) ; un signal d'initialisation (R) appliqué à une entrée de remise à l'état initial (R1) du premier circuit bistable (41) par l'intermédiaire d'un inverseur (43) ; et une porte logique NON-OU (46) ayant deux entrées et recevant ladite fréquence de sortie (CKOUT) et le signal de la sortie négative (QN2) du second circuit bistable (42) pour produire ledit signal de validation (RD).

6.  Appareil de télévision à haute résolution d'image, caractérisé en ce qu'il comprend un dispositif électronique pour la conversion automatique des fréquences d'échantillonnage selon la revendication 1.

FIG.1

FIG.2

FIG.3

40

RD

CK_OUT

CK_IN

38

30

38

CTL

13

30

# FIG.4

FIG.5